# EUROPEAN PATENT APPLICATION

(11) **EP 4 611 252 A1**
(43) Date of publication of application: **03.09.2025**
(21) Application number: 22963401.9
(22) Date of filing: 25.10.2022
(51) Int. Cl.: H02P 29/024, H02K 5/00

(54) **VEHICULAR ELECTRONIC CONTROL DEVICE AND ELECTRIC POWER STEERING DEVICE**

(71) Applicant: Mitsubishi Electric Mobility Corporation, Tokyo 100-8310 (JP)
(72) Inventor: AKIYAMA, Shuzo, Tokyo 100-8310 (JP)
(74) Representative: Hoffmann Eitle
(86) International application number: PCT/JP2022/039598
(87) International publication number: WO 2024/089749

(57) **Abstract**

A vehicular electronic control device includes a controller (6) that controls a motor (4), a connector (7) that connects the controller to an outside thereof, and a water detection portion (15) that is provided on an inside of the controller or on an inside of the connector, and detects water that accumulates below on the inside of the controller or on the inside of the connector in the vertical direction (VD).

## Description

### Technical Field

The present disclosure relates to a vehicular electronic control device, and an electric power steering device.

### Background Art

An electric power steering device includes a motor that generates steering assist torque with respect to vehicle steering, and a controller (vehicular electronic control device) that controls said motor, and applies a steering assist torque to a steering mechanism of a vehicle or the like. In such power steering device, a mechanism for converting rotational power of output shaft of the motor to power in an axial direction of a rack bar and transmitting motive power to the rack bar, is included.

Although a portion of the rack bar and the mechanism for transmitting motive power are housed in a housing having a water-resistant structure, when water leaks to an inside of the housing, the water leaks to an inside of the motor from an output side of the motor, passing through the mechanism for transmitting motive power. In Patent Document 1 below, based on a change in a resistance between a motor power line and a motor case, a technology for detecting water leakage is disclosed.

### Citation List

### Patent Documents

Patent Document 1: Japanese Patent No. 6459492

### Summary of Invention

### Problem to be Solved by the Invention

In a case where an electrical short circuit occurs between a motor power line and a motor case, a function of steering assist by a power steering device is lost. Therefore, to prevent an electrical short circuit due to variability in dimensions during manufacturing and/or assembly, it is important to provide sufficient clearance between the motor power line and the motor case when manufacturing and/or assembling the motor power line and the motor case.

In a case where a gap between the motor power line and the motor case is large, a resistance value for a resistance used to detect water leakage becomes large, and since a change in the resistance depends on an amount of water that leaks, a detection variability becomes large, and a detection accuracy decreases. Also, since a change in voltage is always present in the motor power line due to PWM (Pulse Width Modulation: Pulse Width Modulation) during operation or the like of the motor, it is difficult to monitor a change in the resistance due to water leakage between the motor power line and the motor case with high accuracy, using terminal voltage only.

The present disclosure is made with the above problem in mind, and an object is to provide a vehicular electronic control device and an electric power steering device that is capable of detecting water leakage with high accuracy, regardless of whether a motor is in operation or not.

### Means to Solve the Problem

To resolve the above problem, a vehicular electronic control device includes a controller that controls a motor, a connector that connects the controller to an outside thereof, and a water detection portion that is provided on an inside of the controller or on an inside of the connector, and detects water that accumulates below on the inside of the controller or on the inside of the connector in the vertical direction.

An electronic power steering device according to an embodiment of the present disclosure includes a motor that generates steering assist torque with respect to vehicle steering, and the vehicular control device mentioned above to control drive of the motor.

### Effects of the Invention

According to the present disclosure, it is possible to achieve an effect of detecting water leakage with high accuracy, regardless of whether a motor is in operation or not.

### Brief Description of Drawings

[FIG. 1] A block diagram that shows main components of an electric power steering device, according to a first embodiment of the present disclosure.
[FIG. 2] A view that shows a schematic diagram of a vehicular electronic control device, according to the first embodiment of the present disclosure.
[FIG. 3] A block diagram that shows a circuit configuration of a controller, in the first embodiment of the present disclosure.
[FIG. 4] A view that shows a configuration example of a water detection pad, in the first embodiment of the present disclosure.
[FIG. 5] A block view that shows a modified example of the controller, in the first embodiment of the present disclosure.
[FIG. 6] A schematic block diagram that shows the vehicular electronic control device, according to a second embodiment of the present disclosure.
[FIG. 7] A schematic block diagram that shows a circuit configuration of the vehicular electronic control device, according to the second embodiment.
[FIG. 8] A view that shows a configuration example of a water detection terminal, in the second embodiment of the present disclosure.

### Description of Embodiments

Hereinafter, embodiments of a vehicular electronic control device and an electric power steering device according to the present disclosure are explained with reference to the drawings. In the various embodiments below, same components have same reference symbols affixed thereto, with redundant explanations thereof being omitted.

### First Embodiment

### <Electric Power Steering Device>

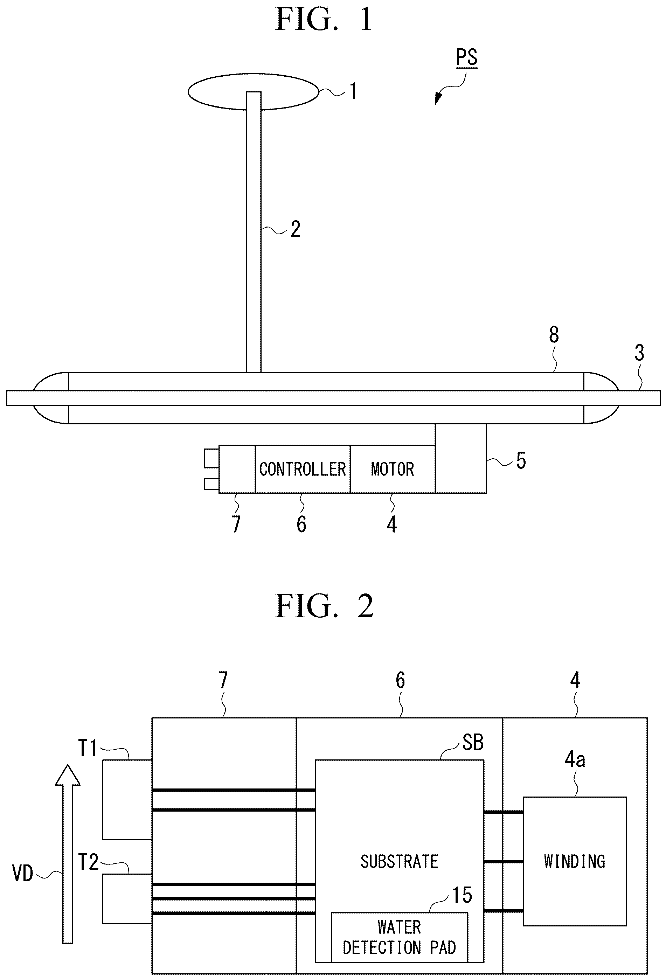

FIG. 1 is a block diagram that shows main components of an electric power steering device, according to a first embodiment of the present disclosure. As shown in FIG. 1, an electric power steering device PS according to the present embodiment has a steering wheel 1, a steering axis 2, a rack bar 3, a motor 4, a mechanism for transmitting motive power 5, a controller 6 (vehicular electronic control device), a connector 7 (vehicular electronic control device), and a housing 8.

The steering wheel 1, otherwise a handle, is used by an operator of a vehicle to operate a vehicle by applying a steering angle to a vehicle steering wheel (omitted from the drawings). The steering axis 2 is linked to the steering wheel 1, and rotates according to a rotation of the steering wheel 1. The rack bar 3 is joined to the steering axis 2, and moves in an axial direction, according to a rotation of the steering axis 2. Further, a steering mechanism not shown on the drawings, which causes the steering wheel to steer, and includes the steering wheel 1, the steering axis 2, and the rack bar 3, shall be referred to as "steering".

The motor 4 applies steering assist torque to the steering, under the control of the controller 6. The motor 4 for example, is a three-phase winding brushless motor, configured of a U phase windings, V phase windings, and W phase windings. Further, the motor 4 may be a brushed motor, and may be a multi-phase motor having multiple windings. The mechanism for transmitting motive power 5 converts rotational power of an output shaft of the motor 4 to power in the axial direction of the rack bar 3, and transmits the converted power to the rack bar 3.

The controller 6 controls a drive of the motor 4, and causes steering assist torque to be generated with respect to the steering, based on detection results from various sensors (omitted from the drawings) that detect steering torque of the steering wheel 1, and the steering angle or the like. The connector 7 connects the controller 6 (for example, another ECU (Electronic Control Unit) provided in the vehicle) to an outside thereof. The housing 8 houses the rack bar 3 and the mechanism for transmitting motive power 5. Furthermore, a portion of the rack bar 3 and the mechanism for transmitting motive power 5 are housed in a water-resistant structure of the housing 8.

### <Vehicular Electronic Control Device>

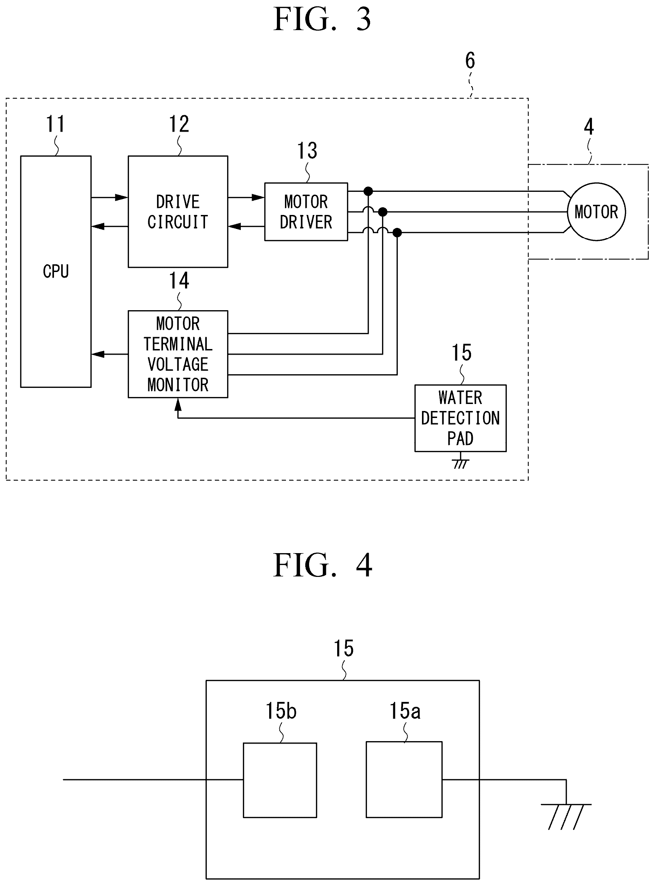

FIG. 2 is a view that shows a schematic diagram of a vehicular electronic control device, according to the first embodiment of the present disclosure. As shown in FIG. 2, the controller 6, which makes up a portion of the vehicular electronic control device includes a substrate SB, which along with forming a circuit pattern, has various electronic components are mounted thereon. The controller 6 executes functions by the circuit pattern formed on the substrate SB (shown in FIG. 3).

The substrate SB includes the substrate SB that has an outer surface thereof established along the vertical direction VD. The substrate SB is connected to a winding 4a that is housed on an inside of the motor case (omitted from the drawings) of the motor 4, and to terminals T1 and T2 that are provided in the connector 7. The connector 7 may be disposed on a side of the controller 6, or disposed above or below the controller 6. It is preferable that the terminals T1 and T2 are disposed so as to be above, more than a water detection pad 15 (details of which are mentioned later on).

FIG. 3 is a block diagram that shows a circuit configuration of the controller, in the first embodiment of the present disclosure. As shown in FIG. 3, the controller 6 includes a CPU 11 (Central Processing Unit), a drive circuit 12, a motor driver 13, a motor terminal voltage monitor 14, and a water detection pad 15 (water detection portion).

The CPU 11 outputs a control signal that controls the drive circuit 12, based off of results from the various sensors (steering torque of the steering wheel 1 sensor, and the steering angle sensor). Under the control of the CPU 11, the drive circuit 12 generates the drive signal needed to drive the motor driver 13. A sensor that detects current that flows to the motor driver 13 is provided in the drive circuit 12. Said sensor outputs the detection results to the CPU 11.

The motor driver 13 drives the motor 4, based on the drive signal that is output from the drive circuit 12. The motor driver 13 for example, converts a direct-current power supplied from an outside power source to an alternating-current power, and includes an inverter that supplies the converted alternating-current power (U phase power, V phase power, and W phase power) to the motor 4. The motor terminal voltage monitor 14 monitors each phase (U phase, V phase, W phase) of the various phases of the terminal voltage of the motor 4. The terminal voltages that are monitored at the motor terminal voltage monitor 14 are output to, and are monitored by the CPU 11.

The water detection pad 15 is formed on the substrate SB, and is a pad used to detect water that accumulates below on an inside of the controller 6 in the vertical direction VD. The water detection pad 15 for example, is formed as part of the circuit pattern of the substrate SB. As shown in FIG. 2, the water detection pad 15 is disposed on the substrate SB, on the lowest portion in the vertical direction VD. Specifically, it is preferable that the water detection pad 15 be disposed in a location that is below, more than the other electronic components and a transmission via that are on the substrate SB. This is so that, when water leaks, it is possible to detect the water before abnormalities or the like occur in a transmission current to the motor 4, due to the other electronic components and the transmission via being affected by the water.

FIG. 4 is a view that shows a configuration example of a water detection pad, in the first embodiment of the present disclosure. As shown in FIG. 4, the water detection pad 15 includes rectangular shaped pads 15a and 15b, which are formed at a preset interval. Depending on required detection sensitivity, it is possible to freely set the interval between the pads 15a and 15b. The pad 15a is connected to ground, and the pad 15b is connected to the motor terminal voltage monitor 14. When the water detection pad 15 is immersed in water, values of resistance of the pads 15a and 15b change. As such, it is possible to detect water that accumulates below on the inside of the controller 6 in the vertical direction VD, using the aforementioned resistance.

As shown in FIG. 3, the water detection pad 15 is connected to the motor terminal voltage monitor 14. The motor terminal voltage monitor 14 is such that an output voltage changes depending on a change in the resistance of the water detection pad 15. The CPU 11 decides whether an abnormality exists or not based on the output voltage of the motor terminal voltage monitor 14.

In the aforementioned configuration, when water leaks to the inside of the controller 6, the leaked water accumulates below the controller 6 in the vertical direction VD. When an amount of water that leaks below on the inside of the controller 6 in the vertical direction VD increases, and the pads 15a and 15b that are provided in the water detection pad 15 are immersed in water, the resistance of the water detection pad 15 changes. When the resistance of the water detection pad changes, the output voltage of the motor terminal voltage monitor 14 changes. Accordingly, the CPU 11 decides that an abnormality has occurred.

As mentioned above, in the present embodiment, the water that accumulates below on the inside of the controller 6 in the vertical direction VD is made to be detected by the change in the resistance of the water detection pad 15, which is provided on the lowest portion of the substrate SB in the vertical direction VD, included in the controller 6. In the present embodiment, since the water detection pad 15 is formed as part of the circuit pattern of the substrate SB, it is possible to freely set the interval between the pads 15a and 15b, depending on the required detection sensitivity, and it is possible to have discrepancies in the interval between the pads 15a and 15b be small. As such, compared to prior arts (arts which have a feature of detecting water that has leaked to a motor, based on a change in a resistance between a motor power line and a motor case), increasing detection sensitivity is easier.

As opposed to the change in resistance between the motor power line and the motor case as in the prior arts, in the present embodiment, an exclusive water detection pad 15 that is formed on the substrate SB is used to detect water that accumulates below on the inside of the controller 6 in the vertical direction VD. As such, even if the motor 4 is operating, since the water detection pad 15 is not affected by a change in the motor terminal voltage, it is possible to highly accurately detect leaked water regardless of whether the motor 4 is operating or not.

In the present embodiment, in a case where the water detection pad 15 is connected to the motor terminal voltage monitor 14, and the resistance of the water detection pad 15 changes, the output voltage of the motor terminal voltage monitor 14 is made to change. Based on the output voltage of the motor terminal voltage monitor 14, the CPU 11 is able to decide whether an abnormality has occurred or not. Accordingly, there is no need for an extra detection circuit, making it possible to suppress an increase in component area, as well as an increase in cost.

In the aforementioned embodiment, a case where one water detection pad 15 is formed in the lowest portion on the established substrate SB is explained. However, a plurality of water detection pads 15 may be formed in the highest portion on the substrate SB. By having a plurality of water detection pads 15 formed, even if an attachment angle of the controller 6 with respect to the vehicle body changes, it is possible to have at least one of the plurality of water detection pads 15 be disposed on the aforementioned lowest portion.

### <Modification Example of the Controller>

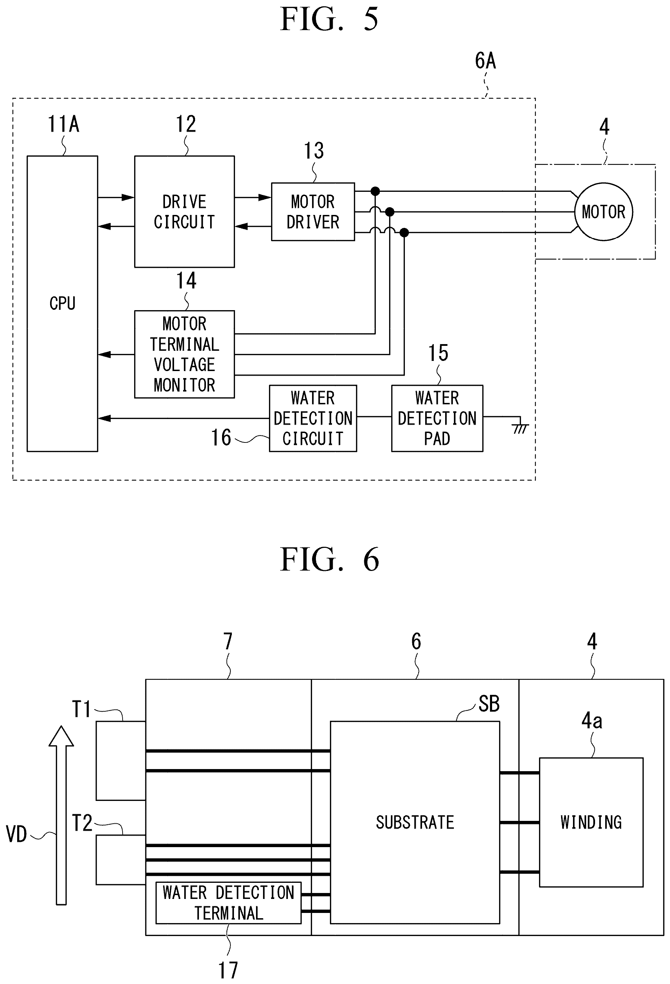

FIG. 5 is a block view that shows a modified example of the controller, in the first embodiment of the present disclosure. In FIG. 5, the same reference signs as reference signs of blocks shown in FIG. 3 are affixed thereto. A controller 6A according to the present embodiment shown in FIG. 5 has a water detection circuit 16 (water detection portion) added to the controller 6 of FIG. 3, and has a configuration where the CPU 11 of controller 6 shown in FIG. 3 is replaced with a CPU 11A.

The water detection circuit 16 is provided between the water detection pad 15 and the CPU 11A, detects water based on the change in resistance of the water detection pad 15, and outputs results thereof to the CPU 11A. The water detection circuit 16 for example, is configured to include a conversion circuit that converts the resistance of the water detection pad 15 to a voltage, and include a comparison circuit that compares the converted voltage to a decision threshold voltage for determining whether water exists or not. Such a configuration of the water detection circuit 16 makes it possible to adjust the detection sensitivity by only changing the decision threshold voltage, without having to change the water detection pad 15. As such, when changing the detection sensitivity, extra labor and cost for changing the substrate SB are not required.

The CPU 11A is configured to be almost the same as the CPU 11 shown in FIG. 3. However, in CPU 11A, whether an abnormality exists or not is decided not by the output voltage of the motor terminal voltage monitor 14, but by the detection results of water that are output from the water detection circuit 16.

The water detection circuit 16, for example, may be a configuration that only has a conversion circuit to convert the resistance of the water detection pad 15 to a voltage. In such a configuration, the converted voltage is output to the CPU 11A, and the CPU 11A determines whether water exists or not. The decision threshold value for determining whether water exists or not is easily changeable, using a program at the CPU 11A. As such, when changing the detection sensitivity, extra labor and cost for changing the substrate SB are not required.

### Second Embodiment

### <Electric Power Steering Device>

An electric power steering device according to the present embodiment has the same configuration as the electric power steering device PS shown in FIG. 1. In other words, a configuration that includes the steering wheel 1, the steering axis 2, the rack bar 3, the motor 4, the mechanism for transmitting motive power 5, the controller 6, the connector 7, and the housing 8. As such, explanations of details regarding the electric power steering device of the present embodiment are omitted.

### <Vehicular Electronic Control Device>

FIG. 6 is a schematic block diagram that shows a vehicular electronic control device, according to a second embodiment of the present disclosure. The same reference symbols shown in the configuration of FIG. 2 are affixed to the same configuration shown in FIG. 6. As shown in FIG. 6, in the present embodiment, a water detection terminal 17 (water detection portion) is provided in the connector 7 that makes up a portion of the vehicular electronic control device, and the water detection pad 15 of the controller 6 that makes up a portion of the vehicular electronic control device (refer to FIG. 2) is abbreviated. In other words, in the present embodiment, the water detection terminal 17 of the connector 7 is provided in place of the water detection pad 15 of the controller 6.

The water detection terminal 17 is disposed on the lowest portion on an inside of the connector 7 in the vertical direction VD. Specifically, it is preferable that the water detection terminal 17 is disposed in a location that is lower than a location in which the substrate SB is provided in the controller 6. This is done so that, when water leakage occurs, the water leakage is detected before any abnormality or the like occurs to the motor 4, even if the electronic components and the transmission via provided in the substrate SB are affected by the water. A connector, such as the aforementioned connector 7, is connected to the substrate SB of the controller 6.

In the first embodiment, the connector 7 may be disposed on any of a side, above, or below the controller 6. However, in the present embodiment, the connector 7 is disposed on the side, or below the controller 6, so that the electronic components and the transmission via that are provided in the substrate SB of the controller 6 are not affected by the water.

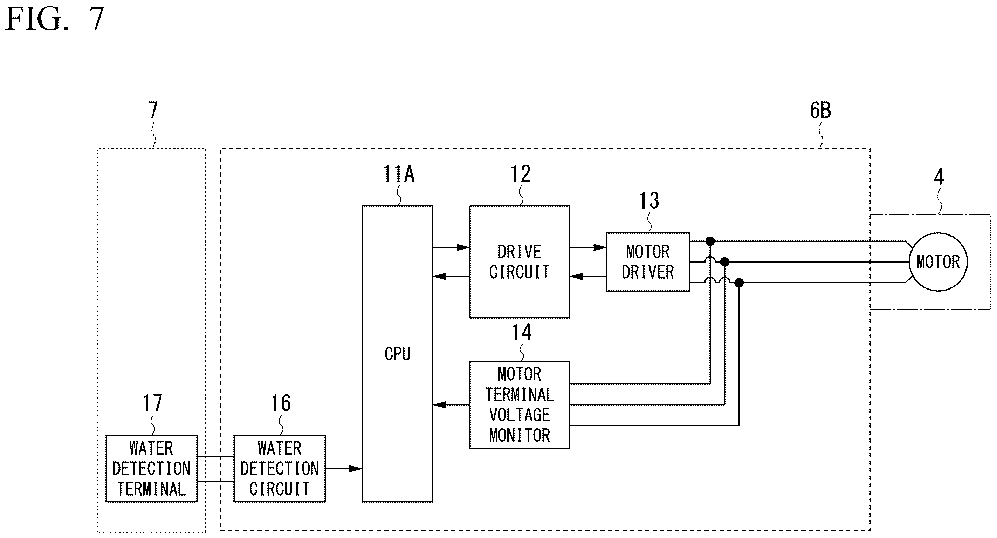

FIG. 7 is a schematic block diagram that shows a circuit configuration of the vehicular electronic control device, according to the second embodiment. As shown in FIG. 7, the vehicular electronic control device according to the present embodiment includes a controller 6B, and the connector 7. The controller 6B includes the water detection pad 15, which the controller 6A shown in FIG. 5 includes, and thus a configuration thereof is omitted. The water detection circuit 16 of the controller 6B is connected to the water detection terminal 17 that is provided in the connector 7.

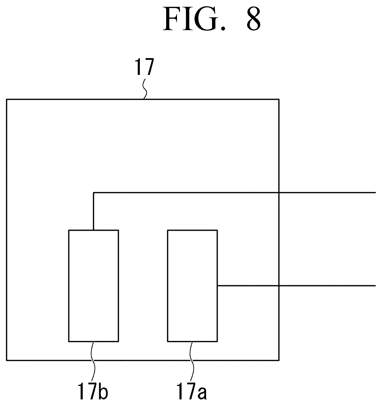

FIG. 8 is a view that shows a configuration example of a water detection terminal, in the second embodiment of the present disclosure. As shown in FIG. 8, the water detection terminal 17 includes rectangular shaped terminals 17a and 17b, which are formed at a preset interval. Since the water detection terminal 17 is for example formed by insert resin forming or outsert resin forming, depending on the required detection sensitivity, it is possible to freely set the interval between the terminals 17a and 17b. Both of the terminals 17a and 17b are connected to the water detection circuit 16 of the controller 6B. When the water detection terminal 17 is immersed in water, a change in the resistance between the terminals 17a and 17b occurs. The water detection circuit 16 detects water based on a change in a resistance of the water detection terminal 17, and outputs results thereof to the CPU 11A. The CPU 11A decides whether an abnormality exists or not, based on the water detection results that are output form the water detection circuit 16. As such, it is possible to detect water that accumulates below the connector 7 in the vertical direction VD.

In the aforementioned configuration, when water leaks into the connecter 7, the leaked water accumulates below the connector 7 in the vertical direction VD. When an amount of water that accumulates below the connector 7 in the vertical direction VD increases, and the terminals 17a and 17b that are provided in the water detection terminal 17 are both immersed in water, the resistance of the water detection terminal 17 changes. Then, the voltage that is converted at the water detection circuit 16 changes, and as a result, comparison results with the decision threshold voltage change. Accordingly, detection results that show that water has been detected are output from the water detection circuit 16, and the CPU 11A decides that an abnormality has occurred, based on the detection results of the water detection circuit 16.

As mentioned above, in the present embodiment, the water detection terminal 17 is provided on the lowest portion of the connector 7 in the vertical direction VD, and detects water that accumulates below in the vertical direction VD of the connector 7, due to a change in the resistance of the water detection terminal 17. In the present embodiment, since the water detection terminal 17 is formed by insert resin forming or outsert resin forming, along with making it possible to freely set the interval between the terminals 17a and 17b to match the required detection sensitivity, it is possible to have discrepancies in the interval between the terminals 17a and 17b be small. As such, compared to prior arts (arts which have a feature of detecting water that has leaked to a motor, based on a change in a resistance between a motor power line and a motor case), increasing detection sensitivity is easier.

As opposed to the change in resistance between the motor supply line and the motor case as in the prior arts, in the present embodiment, the water detection terminal 17 is exclusively provided in the connector 7 to detect water that accumulates below on the inside of the connector 7 in the vertical direction VD,. As such, even if the motor 4 is operating, since the water detection terminal 17 is not affected by a change in the motor terminal voltage, it is possible to highly accurately detect leaked water regardless of whether the motor 4 is operating or not.

In the present embodiment, the water detection terminal 17 is connected to the water detection circuit 16 of the control device 6B, the resistance of the water detection terminal 17 is converted to a voltage, and water is detected by comparing results of the converted voltage with the decision threshold voltage. As such, in the present embodiment, by only changing the decision threshold voltage, it is possible to adjust the detection sensitivity without having to change the water detection terminal 17. Therefore, labor and cost of changing the connector 7, when changing the detection sensitivity are not required.

As shown in the modification example of the first embodiment, the water detection circuit 16 for example, may be a configuration that only includes a conversion circuit that converts resistance of the water detection terminal 17 to a voltage. In such a configuration, the voltage converted at the conversion circuit is output to the CPU11A, and it is possible for the CPU11A to determine whether water exists or not. It is possible to update the program used by the CPU11A to determine the threshold value, used to determine whether water exists or not. Therefore, labor and cost of changing the connector 7, when changing the detection sensitivity are not required.

In the embodiment explained above, an example where one water detection terminal 17 is provided on the lowest portion of the connector 7 is explained. However, a plurality of water detection terminal 17 may be provided on the lowest portion of the connector 7. By providing the plurality of water detection terminal 17 for example, even if an attachment angle of the control device 6B with respect to the vehicle body changes, it is possible to have at least one of the plurality of water detection terminal 17 be disposed on the lowest portion of the connector 7.

Although embodiments of the present disclosure are explained above, the present disclosure is not limited to the various configurations and methods explained above, with changes being made as needed, so long as a technical scope thereof does not departed therefrom.

### Reference Signs List

4...Motor, 6, 6A, 6B...Controller, 7...Connector, 11, 11A...CPU, 14...Motor Terminal Voltage Monitor, 15...Water Detection Pad, 15a, 15b... Pad, 16... Water Detection Circuit, 17... Water Detection Terminal, 17a, 17b... Terminal, PS... Electric Power Steering Device, SB...Substrate, VD... Vertical Direction

## Claims

1. A vehicular electronic control device comprising:
a controller that controls a motor;
a connector that connects the controller to an outside thereof; and
a water detection portion that is provided on an inside of the controller or on an inside of the connector, and detects water that accumulates below on the inside of the controller or on the inside of the connector in the vertical direction.

2. The vehicular electronic control device according to claim 1, wherein the water detection portion comprises a water detection pad that is formed on a substrate on the inside of the controller.

3. The vehicular electronic control device according to claim 2, wherein
the water detection pad is located below, more than other electronic components and a transmission via that are on the substrate.

4. The vehicular electronic control device according to claim 2 or 3, wherein the controller further comprises:
a motor terminal voltage monitor that monitors a terminal voltage of the motor; and
a CPU that monitors monitor results of the motor terminal voltage monitor; wherein
the water detection pad is connected to the motor terminal voltage monitor,
the motor terminal voltage monitor is such that an output voltage changes depending on a change in a resistance of the water detection pad, and
the CPU decides whether an abnormality exists or not based on the output voltage of the motor terminal voltage monitor.

5. The vehicular electronic control device according to claim 2 or 3, wherein
the water detection portion comprises a water detection circuit that detects water, which accumulates on the inside of the controller, depending on a change in the resistance of the water detection pad; and
the controller comprises a CPU that decides whether or not an abnormality exists, based on detection results of the water detection circuit.

6. The vehicular electronic control device according to claim 1, wherein the water detection portion comprises: a water detection terminal that is provided on the inside of the connector.

7. The vehicular electronic control device according to claim 6, wherein
the water detection terminal is disposed in a location that is lower than the location in which the substrate on the inside of the controller is provided in.

8. The vehicular electronic control device according to claim 6 or 7, wherein
the water detection portion comprises a water detection portion that detects water, which accumulates on the inside of the controller, depending on a change in a resistance of the water detection terminal; and
the controller comprises a CPU that decides whether or not an abnormality exists, based on detection results of the water detection circuit.

9. An electronic power steering device comprising:
a motor that generates steering assist torque with respect to vehicle steering; and
the vehicular control device according to any one of claims 1 to 8 that controls drive of the motor.
